# EUROPÄISCHE PATENTSCHRIFT

(11) **EP 2 929 762 B1**
(45) Veröffentlichungstag und Bekanntmachung des Hinweises auf die Patenterteilung: **26.12.2018**
(21) Anmeldenummer: 13774673.1
(22) Anmeldetag: 11.10.2013
(51) Int. Cl.: H05K 5/00, H05K 1/11

(54) **ELEKTRONISCHE ANORDNUNG MIT LEITERPLATTE**
ELECTRONIC ARRANGEMENT COMPRISING A CIRCUIT BOARD
DISPOSITIF ÉLECTRONIQUE DOTÉ D'UNE CARTE DE CIRCUIT IMPRIMÉ

(30) Priorität: 10.12.2012 DE 102012222674
(43) Veröffentlichungstag der Anmeldung: 14.10.2015
(73) Patentinhaber: Robert Bosch GmbH, 70442 Stuttgart (DE)
(72) Erfinder: GUECKEL, Richard, 71701 Schwieberdingen (DE); KROECKEL, Markus, 71701 Schwieberdingen (DE)
(86) Internationale Anmeldenummer: PCT/EP2013/071254
(87) Internationale Veröffentlichungsnummer: WO 2014/090433

(56) Entgegenhaltungen:
- DE-A1- 10 162 405
- DE-A1-102010 025 086
- US-B1- 6 282 099

## Beschreibung

### Stand der Technik

Die vorliegende Erfindung betrifft eine elektronische Anordnung mit einer direkt kontaktierbaren Leiterplatte, bei der ein Stecker einen direkten elektrischen Kontakt auf der Leiterplatte herstellt.

Es ist bekannt, eine sogenannte Direktsteckverbindung zwischen einer Leiterplatte und einem Stecker herzustellen, bei der die elektrischen Kontakte des Steckers direkt auf Kontaktflächen an der Leiterplatte aufgesteckt werden. Die Leiterplatte kann hierbei Teil eines Steuergeräts sein oder auch Teil einer elektrischen Baugruppe, z.B. einem elektrischen Antrieb. Hierbei können sich jedoch Probleme hinsichtlich einer Verschmutzung im Kontaktbereich bzw. ein Eintrag von Schutz in das Innere des Steuergeräts ergeben. Weiterhin müssen Berührschutzanforderungen im Kontaktbereich erfüllt werden. Aus der DE 10201002511 A1 ist beispielsweise ein elektrischer Fensterheberantrieb bekannt, bei dem eine derartige Direktsteckverbindung realisiert ist. Ein Problemkreis derartiger Direktsteckverbindungen liegt nun darin, dass die Leiterplatten häufig unterschiedliche Dicken aufweisen. Aufgrund dieser vergleichsweise großen Toleranzen einer Dicke einer Leiterplatte kommt es zu einer asymmetrischen Anordnung der Leiterplatte relativ zu einem Steckerkragen und gegebenenfalls einer asymmetrischen Kraftbeaufschlagung bei der Kontaktierung. Aufgrund der von vielen Anwendern gewünschten kleinen Baugrößen führt dies jedoch zu Problemen bei der Kontaktierung bishin zu Beschädigungen der Leiterplatte und/oder des Steckers während des Aufsteckvorgangs. Die US 6,282,099 B1 offenbart eine elektronische Anordnung gemäß dem Oberbegriff des Anspruches 1. Ferner ist aus der DE 10 2010 025 086 A1 eine elektronische Anordnung mit einer feuchtigkeitsdichten Verbindung zwischen einem Stecker und einer Baugruppe offenbart. Weiterhin zeigt die DE 101 62 405 A1 eine elektronische Anordnung mit einer Direktkontaktierung mit Kontaktpads auf einer Leiterplatte, welche in direktem Kontakt mit einem Stecker bringbar sind.

### Offenbarung der Erfindung

Die erfindungsgemäße elektronische Anordnung mit den Merkmalen des Anspruchs 1 weist demgegenüber den Vorteil auf, dass ein sicherer Toleranzausgleich bei einer direkt kontaktierbaren Leiterplatte möglich ist. Hierbei ist ein besonderer Vorteil, dass die erfindungsgemäße Lösung nicht zu einer Vergrößerung des Bauraums führt. Trotzdem können unterschiedliche Leiterplattendicken sicher ausgeglichen werden. Dies wird erfindungsgemäß dadurch erreicht, dass die eine elektrische Kontaktfläche für einen Direktkontakt aufweisende Leiterplatte in einem Gehäuse mit einem Steckerkragen angeordnet ist und die Leiterplatte an einer ersten Leiterplattenhälfte mit einem Lager abgestützt werden kann. Das Lager zur Abstützung der Leiterplatte ist dabei derart ausgebildet, dass das Lager einen Schwenkbereich der Leiterplatte definiert, um welchen die Leiterplatte schwenkbar ist. Somit ist die Leiterplatte schwenkbar im Gehäuse angeordnet und kann somit unterschiedliche Leiterplattendicken sicher ausgleichen. Das Lager für die Leiterplatte ist vorzugsweise in einem dem Steckerkragen abgewandten Bereich der Leiterplatte vorgesehen, um eine ausreichende Beweglichkeit der Leiterplatte mit möglichst nur einem minimalen Schwenkwinkel zu erreichen. Der Schwenkwinkel ist vorzugsweise in einem Bereich von ± 10° um eine Horizontalebene, besonders bevorzugt in einem Bereich von ± 5°. Erfindungsgemäß erfolgt somit eine endgültige Fixierung der Leiterplatte erst nach Einschieben eines Steckers in den Steckerkragen.

Die Unteransprüche zeigen bevorzugte Weiterbildungen der Erfindung.

Besonders bevorzugt umfasst das Lager einen oberen Lagerzapfen und einem unteren Lagerzapfen, wobei die Leiterplatte zwischen dem oberen und unteren Lagerzapfen gelagert ist. Die Verwendung der Lagerzapfen ermöglicht eine Punktlagerung der Leiterplatte und kann einfach und kostengünstig bereitgestellt werden. Erfindungsgemäß wird hierbei unter einer Punktlagerung auch eine Lagerung mit einer sehr kleinen Fläche, beispielsweise einer kleinen Kreisfläche des Lagerzapfens, verstanden, welche im Vergleich zur Größe der Leiterplatte eine Quasi-Punkt-Lagerung ermöglicht.

Weiter bevorzugt weist die Leiterplatte wenigstens eine Durchgangsöffnung auf, wobei der obere und/oder untere Lagerzapfen in die Durchgangsöffnung eingeführt ist und vorzugsweise durch die Durchgangsöffnung hindurchgeführt ist. Hierdurch kann insbesondere ein Verrutschen der Leiterplatte verhindert werden. Besonders bevorzugt ist dabei einer der Lagerzapfen als Konus ausgebildet und der andere der Lagerzapfen als Hohlzylinder, wobei der Hohlzylinder zur Aufnahme des Konus eingerichtet ist. Insbesondere die Ausgestaltung eines der Lagerzapfen als Konus ermöglicht zusätzlich noch eine Zentrierung der Leiterplatte in der Durchgangsöffnung relativ zum Lager.

Besonders bevorzugt umfasst das Lager einen ersten und zweiten Lagerbereich, welche voneinander beabstandet sind. Vorzugsweise weist das Lager dabei genau zwei obere und zwei obere Lagerzapfen auf. Eine geradlinige Verbindung der beiden Lagerbereiche definiert dabei eine Schwenkachse für die Leiterplatte. Besonders bevorzugt ist diese Schwenkachse dabei senkrecht zu einer Steckerrichtung der elektronischen Anordnung.

Weiter bevorzugt ist an der Leiterplatte in einem Bereich zwischen dem ersten und zweiten Lagerbereich ein elektronisches Bauteil, insbesondere ein empfindliches elektronisches Bauteil, wie z.B. ein Beschleunigungsaufnehmer oder dgl., angeordnet. Das elektronische Bauteil kann dabei an einer Oberseite und/oder an einer Unterseite der Leiterplatte angeordnet sein.

Weiter bevorzugt steht die Leiterplatte teilweise in den Steckerkragen des Gehäuses vor. Hierdurch können die elektrischen Kontakte an der Leiterplatte in diesem in den Steckerkragen vorragenden Bereich angeordnet werden, um einen einfachen elektrischen Kontakt zu realisieren.

Weiter bevorzugt weist die elektronische Anordnung an einem Gehäusedurchbruch zum Steckerkragen ein flexibles Element, vorzugsweise zwei einander gegenüberliegende flexible Elemente auf. Die Leiterplatte berührt dabei wenigstens eines, bevorzugt beide flexiblen Elemente. Die Leiterplatte wird dabei durch das oder die flexiblen Elemente abgestützt, wobei aufgrund der Flexibilität der flexiblen Elemente trotzdem die Schwenkbarkeit der Leiterplatte erhalten bleibt. Dies hat insbesondere den Vorteil, dass beispielsweise bei einem Transport der elektronischen Anordnung, welcher üblicherweise ohne einen eingesteckten Stecker erfolgt, trotzdem die Leiterplatte gehalten wird und nicht im Umfang des Schwenkwinkels schwenken kann und dadurch Beschädigungen erleiden könnte.

Weiter sind am Steckerkragen ein erstes und ein zweites Federelement angeordnet, wobei ein in den Steckerkragen vorstehender Bereich der Leiterplatte zwischen den beiden Federelementen angeordnet ist. Hierdurch kommt es zu einer Zentrierung der Leiterplatte, wenn ein Stecker in den Steckerkragen eingeführt wird und die elektrischen Kontakte des Steckers mit Direktkontakten an der Leiterplatte in Kontakt kommen.
Gemäß einer weiter bevorzugten Ausgestaltung der vorliegenden Erfindung umfasst die elektronische Anordnung ferner eine Transportsicherung. Die Transportsicherung ist eingerichtet, in den Steckerkragen der elektronischen Anordnung aufgenommen zu werden und die Leiterplatte derart zu sichern, dass ein Schwenken der Leiterplatte verhindert wird. Die Transportsicherung kann beispielsweise ein Stopfen oder dgl. sein, wobei die die Leiterplatte berührenden Bereiche der Transportsicherung mit gleichen Geometrien wie ein später einzuführender Stecker ausgebildet sind.
Die elektronische Anordnung wird besonders bevorzugt in Verbindung mit einem Airbag-Steuergerät verwendet.

### Zeichnung

Nachfolgend werden unter Bezugnahme auf die begleitende Zeichnung bevorzugte Ausführungsbeispiele der Erfindung im Detail beschrieben. Gleiche bzw. funktional gleiche Teile sind dabei mit den gleichen Bezugszeichen bezeichnet. In der Zeichnung ist:
- Figur 1: eine schematische Schnittansicht einer elektronischen Anordnung gemäß einem ersten Ausführungsbeispiel der Erfindung,
- Figur 2: eine Draufsicht der Anordnung von Figur 1,
- Figur 3: eine Schnittansicht der Anordnung von Figur 1 und 2 von hinten,
- Figuren 4 bis 6: schematische Detailansichten eines Einschiebevorgangs eines Steckers in die elektronische Anordnung,
- Figur 7: eine elektronische Anordnung gemäß einem zweiten Ausführungsbeispiel der Erfindung,
- Figur 8: eine schematische Ansicht einer elektronischen Anordnung gemäß einem dritten Ausführungsbeispiel der Erfindung,
- Figur 9: eine schematische Ansicht einer elektronischen Anordnung gemäß einem vierten Ausführungsbeispiel der Erfindung.

### Bevorzugte Ausführungsformen der Erfindung

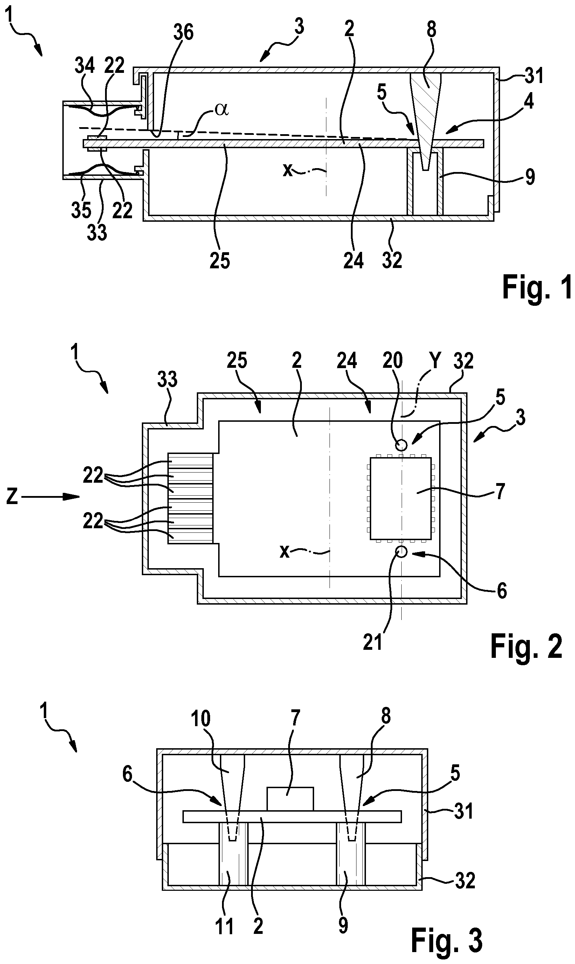

Nachfolgend wird unter Bezugnahme auf die Figuren 1 bis 6 eine elektronische Anordnung 1 gemäß einem ersten bevorzugten Ausführungsbeispiel der Erfindung im Detail beschrieben.

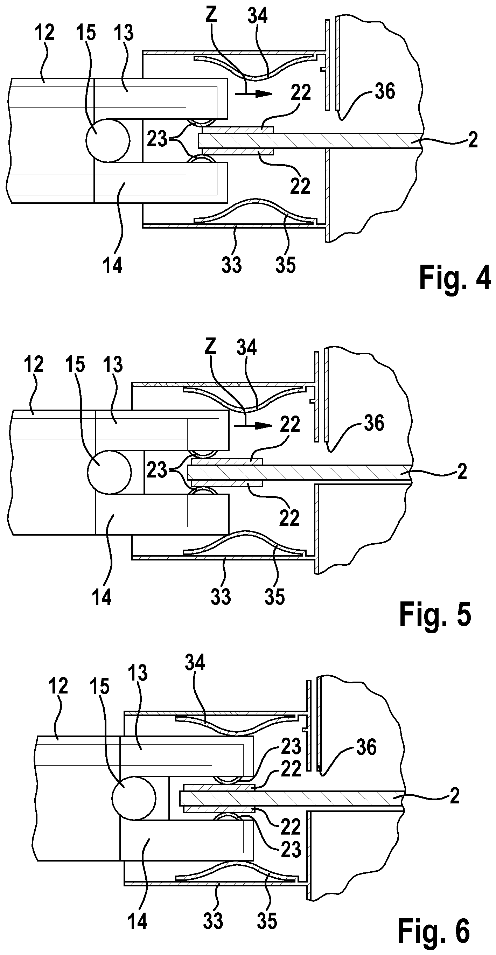

Wie aus Figur 1 ersichtlich ist, umfasst die elektronische Anordnung eine Leiterplatte 2, welche in einem Gehäuse 3 angeordnet ist. Das Gehäuse 3 ist zweiteilig mit einem ersten Teil 31 und einem zweiten Teil 32 gebildet. Ferner umfasst das Gehäuse 3 einen Steckerkragen 33 zur Aufnahme eines Steckers 12 (vgl. Figuren 4 bis 6).

Die elektronische Anordnung 1 umfasst ferner ein Lager 4 zur Abstützung der Leiterplatte 2. Wie aus den Figuren 2 und 3 ersichtlich ist, umfasst das Lager 4 einen ersten Lagerbereich 5 und einen zweiten Lagerbereich 6. Die beiden Lagerbereiche 5, 6 bilden eine im Wesentlichen punktförmige Abstützung für die Leiterplatte 2, so dass eine Gerade Y durch die beiden Lagerbereiche 5, 6 eine Schwenkachse für die Leiterplatte 2 definiert. Wie aus Figur 1 ersichtlich ist, ist die Leiterplatte 2 lediglich in einer ersten Leiterplattenhälfte 24 abgestützt und nicht in einer zweiten Leiterplattenhälfte 25. Die Leiterplatte 2 wird dabei durch eine Mittelachse X in die beiden Leiterplattenhälften 24, 25 unterteilt.

Wie insbesondere aus den Figuren 1 und 3 ersichtlich ist, umfasst der erste Lagerbereich 5 einen konischen ersten Lagerzapfen 8 und einen hohlzylindrischen zweiten Lagerzapfen 9. Der zweite Lagerbereich 6 ist wie der erste Lagerbereich 5 mit einem ersten konischen Lagerzapfen 10 und einem zweiten hohlzylindrischen Lagerzapfen 11 ausgebildet. Hierbei sind die konischen Lagerzapfen 8, 10 durch eine erste und zweite Durchgangsöffnung 20, 21 in der Leiterplatte 2 hindurchgeführt.

Wie weiter aus den Figuren 2 und 3 ersichtlich ist, ist ein elektronisches Bauelement, z.B. ein Beschleunigungssensor, zwischen den beiden Lagerbereichen 5, 6 angeordnet. Hierdurch können sehr empfindliche Bauteile wie der Beschleunigungssensor sicher an der Leiterplatte 2 angeordnet werden, da das elektronische Bauelement 7 in der Schwenkachse Y der Leiterplatte 2 liegt.

Am Steckerkragen 33 ist ferner ein erstes Federelement 34 und eines zweites Federelement 35 angeordnet, welche zwischen sich den Stecker 12 aufnehmen (vgl. Figuren 4 bis 6).

Die Leiterplatte 2 weist ferner elektrische Kontakte 22 auf, welche, wie insbesondere aus den Figuren 1 und 2 ersichtlich ist, im Bereich des Steckerkragens 33 des Gehäuses 3 angeordnet sind. Somit stehen die elektrischen Kontakte an der Leiterplatte für eine Direktkontaktierung unmittelbar in den Steckerkragen 33 vor. Der Steckerkragen 33 ist dabei vorzugsweise am zweiten Teil 32 des Gehäuses 3 angeordnet.

Durch die einseitige Lagerung der Leiterplatte 2 ist es somit möglich, dass die Leiterplatte um die Schwenkachse Y in einem Winkel α schwenken kann. Der Schwenkwinkel wird hierbei durch einen Durchbruch 36 im Gehäuse 3 zum Steckerkragen 33 beschränkt.

Die endgültige Fixierung der Leiterplatte 2 erfolgt dann durch Einschieben eines Steckers 12, was in den Figuren 4 bis 6 dargestellt ist. Der Stecker 12 weist einen oberen Kontaktträger 13 und einen unteren Kontaktträger 14 auf, welche zwischen sich die Leiterplatten 2 aufnehmen. An den nach Innen gerichteten Bereichen der Kontaktträger 13, 14 sind jeweils elektrische Kontakte 23 zur Kontaktierung der elektrischen Kontakte 22 der Leiterplatte 2 angeordnet.

Vorzugsweise sind die beiden Kontaktträger 13, 14 an einem Gelenk 15 gelenkig gelagert, um ein individuelles Einführen der beiden Kontaktträger 13, 14 zu ermöglichen.

Die äußeren Flächen der Kontaktträger 13, 14 kommen dabei mit den Federelementen 34, 35 des Steckerkragens 33 in Kontakt und werden durch diese zentriert.

Der Einschiebevorgang beginnt, wie in Figur 4 gezeigt, derart, dass die elektrischen Kontakte 23 mit der Leiterplatte bzw. dem Beginn der elektrischen Kontakte 22 der Leiterplatte in Kontakt treten. Anschließend wird der Stecker 12 in Richtung des Pfeils Z weiter eingeführt, wobei die Endposition zwischen Stecker 12 und Leiterplatte 2 noch nicht definiert ist. Bei weiteren Einführungen, wie in Figur 5 dargestellt, kommen die Kontaktträger 13, 14 mit den Federelementen 34, 35 in Kontakt, so dass eine Zentrierung zwischen dem Stecker 12 und dem Steckerkragen 33 beginnt. Figur 6 zeigt den vollständig eingeschobenen Zustand des Steckers in den Steckerkragen 33, wobei zusätzlich noch ein Anschlag (nicht dargestellt) am Steckerkragen oder an einem anderen Teil des Gehäuses vorgesehen werden kann. Die Zentrierung der Einheit Leiterplatte/Stecker 12 erfolgt dabei über die Federelemente 34, 35 im Steckerkragen. Auf die Leiterplatte 2 selbst wirkt nur eine Federkraft der elektrischen Kontakte 23 an den Kontaktträgern 13, 14. Durch diesen dreistufigen Einschiebevorgang wird insbesondere erreicht, dass eine Anpresskraft über die Federelemente 34, 35 in symmetrischer Weise erst im letzten Schritt erzeugt wird, wenn die Kontaktträger 13, 14 mit den Federelementen 34, 35 in Kontakt treten bzw. die Kontaktträger 13, 14 dann vollständig vorspannen, wie in Figur 6 gezeigt.

Somit wird erfindungsgemäß eine Leiterplatte 2 bereitgestellt, welche um einen Lagerbereich schwenken kann und erst nach Herstellung eines elektrischen Direktkontaktes zwischen der Leiterplatte und einem Stecker zu Federelementen 34, 35 am Steckerkragen 33 symmetrisch fixiert wird.

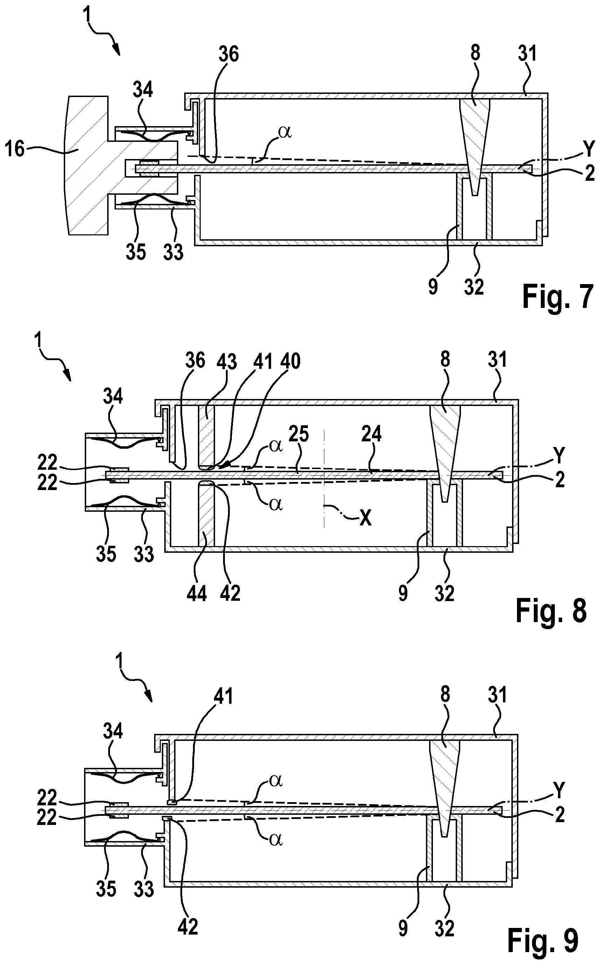

Figur 7 zeigt eine elektrische Anordnung 1 gemäß einem zweiten Ausführungsbeispiel der Erfindung. Die elektrische Anordnung 1 des zweiten Ausführungsbeispiels entspricht im Wesentlichen dem ersten Ausführungsbeispiel, wobei zusätzlich noch ein Transportsicherungselement 16 vorgesehen ist. Das Transportsicherungselement 16 weist Abmessungen entsprechend einem später in den Steckerkragen 33 einzuführenden Stecker auf und wird in gleicher Weise in den Steckerkragen 33 eingeführt. Im eingeführten Zustand stellt das Transportsicherungselement 16 sicher, dass die Leiterplatte 2 nicht schwenken kann, um während eines Transportes Beschädigungen an der Leiterplatte vermeiden zu können. Das Transportsicherungselement ist vorzugsweise aus Kunststoff oder dgl. hergestellt und wird vor dem Einstecken des richtigen Steckers aus dem Steckerkragen 33 entfernt. Somit kann eine Verschmutzung und ein Eintrag von Schmutz in das Innere des Gehäuses vermieden werden. Auch können so Berührschutzanforderungen erfüllt werden.

Figur 8 zeigt eine elektronische Anordnung gemäß einem dritten Ausführungsbeispiel der Erfindung, welche im Wesentlichen ebenfalls dem ersten Ausführungsbeispiel entspricht. Zusätzlich ist beim dritten Ausführungsbeispiel noch ein zweites Lager 40 vorgesehen, welches die Leiterplatte 2 am zweiten Leiterplattenbereich 25 lagert. Hierbei ist das zweite Lager 40 jedoch als nachgiebiges Lager ausgebildet, in dem flexible Elemente 41, 42 an Endbereichen zweier Haltezapfen 43, 44 angeordnet sind. Die Haltezapfen 43, 44 sind am ersten bzw. zweiten Teil 31, 32 des Gehäuses angeordnet. Die Leiterplatte 2 befindet sich, wie aus Figur 8 ersichtlich ist, dabei mit den flexiblen Elementen 41, 42 im Kontakt, welche insbesondere bei einem Transport die Leiterplatte flexibel abstützen. Die flexiblen Elemente 41, 42 weisen dabei eine Flexibilität derart auf, dass trotzdem eine Schwenkbarkeit der Leiterplatte 2 um die Schwenkachse Y sichergestellt ist, wenn ein Stecker in den Steckerkragen 33 eingeschoben wird. Durch das Vorsehen dieser flexiblen Elemente 41, 42 kann einerseits die Beweglichkeit der Leiterplatte eingeschränkt werden und beispielsweise Stöße oder dgl. gedämpft werden, trotzdem kann ein Toleranzausgleich einer Dicke der Leiterplatte 2 erhalten werden.

Das in Figur 9 gezeigte vierte Ausführungsbeispiel der elektrischen Anordnung entspricht im Wesentlichen dem dritten Ausführungsbeispiel, wobei beim vierten Ausführungsbeispiel die flexiblen Elemente 41, 42 am Durchbruch 36 des Gehäuses 3 zum Steckerkragen 33 angeordnet sind. Hierbei befinden sich ebenfalls beide flexiblen Elemente 41, 42 mit der Leiterplatte 2 in Kontakt, um Stöße usw. abzudämpfen, ermöglichen jedoch ein Schwenken der Leiterplatte 2 um die Schwenkachse Y in gewissen Bereichen. Durch die Anordnung der flexiblen Elemente 41, 42 am Durchbruch 36 müssen keine zusätzlichen Haltezapfen am Gehäuse vorgesehen werden, so dass der Aufbau des vierten Ausführungsbeispiels noch einfacher ausgestaltet ist.

## Patentansprüche

1. Elektronische Anordnung, umfassend:
- eine Leiterplatte (2) mit wenigstens einem elektrischen Kontakt (22) zur elektrischen Kontaktierung,
- ein Gehäuse (3), in welchem die Leiterplatte (2) angeordnet ist, und
- ein am Gehäuse (3) angeordneten Steckerkragen (33),
- wobei die Leiterplatte (2) eine erste Leiterplattenhälfte (24) mit einem Lager (4) zum Abstützen der Leiterplatte (2) und eine zweite Leiterplattenhälfte (25) aufweist
wobei der wenigstens eine elektrische Kontakt (22) der Leiterplatte (2) im Bereich des Steckerkragens (33) angeordnet ist, um eine Direktkontaktierung des elektrischen Kontakts zu ermöglichen,
**dadurch gekennzeichnet, dass**
- die Leiterplatte (2) am Lager (4) derart abgestützt ist, dass das Lager (4) einen Schwenkbereich, insbesondere eine Schwenkachse der Leiterplatte (2) definiert, um welchen die Leiterplatte (2) schwenkbar ist,
- wobei am Steckerkragen (33) ein erstes und ein zweites Federelement (34, 35) angeordnet ist, so dass es zu einer Zentrierung der Leiterplatte (2) kommt, wenn ein Stecker in den Steckerkragen (33) eingeführt wird und die elektrischen Kontakte des Steckers mit den elektrischen Kontakten (22) der Leiterplatte in Kontakt kommen, und
- wobei nach Herstellung eines elektrischen Direktkontakts zwischen der Leiterplatte (2) und dem Stecker die Leiterplatte (2) zwischen den Federelementen (34, 35) am Steckerkragen (33) symmetrisch fixiert ist.

2. Anordnung nach Anspruch 1, **dadurch gekennzeichnet, dass** das Lager (4) am Gehäuse (3) einen ersten Lagerzapfen (8) und einen zweiten Lagerzapfen (9) umfasst, welche am Gehäuse einander gegenüberliegend angeordnet sind und zwischen sich die Leiterplatte (2) lagern.

3. Anordnung nach Anspruch 2, **dadurch gekennzeichnet, dass** die Leiterplatte (2) eine Durchgangsöffnung (20, 21) aufweist, in welche der erste und/oder zweite Lagerzapfen (8, 9) vorsteht.

4. Anordnung nach Anspruch 3, **dadurch gekennzeichnet, dass** der erste Lagerzapfen (8) konisch ist und der zweite Lagerzapfen (9) ein Hohlzylinder ist.

5. Anordnung nach einem der vorhergehenden Ansprüche, **dadurch gekennzeichnet, dass** das Lager (4) einen ersten Lagerbereich (5) und einen zweiten Lagerbereich (6) umfasst und jeder Lagerbereich (5, 6) einen ersten und zweiten Lagerzapfen (8, 9; 10, 11) umfasst.

6. Anordnung nach Anspruch 5, **dadurch gekennzeichnet, dass** eine Gerade durch den ersten und zweiten Lagerbereich (5, 6) senkrecht zu einer Einsteckrichtung (Z), in welcher ein Stecker in den Steckerkragen (33) eingeführt wird, ist.

7. Anordnung nach Anspruch 5 oder 6, ferner umfassend ein elektronisches Bauelement (7), welches an der Leiterplatte (2) zwischen dem ersten Lagerbereich (5) und dem zweiten Lagerbereich (6) angeordnet ist.

8. Anordnung nach einem der vorhergehenden Ansprüche, **dadurch gekennzeichnet, dass** die Leiterplatte (2) zumindest teilweise in den Steckerkragen (33) vorsteht.

9. Anordnung nach einem der vorhergehenden Ansprüche, ferner umfassend ein zweites Lager (40), welches zumindest ein flexibles Element (41, 42), vorzugsweise zwei flexible Elemente, umfasst, um die Leiterplatte (2) am zweiten Leiterplattenbereich (25) nachgiebig abzustützen.

10. Anordnung nach Anspruch 9, **dadurch gekennzeichnet, dass** das flexible Element (41, 42) am Durchbruch (36) des Gehäuses (3) zum Steckerkragen (33) angeordnet ist, oder dass das flexible Element (41, 42) an am Gehäuse (3) vorgesehenen Haltezapfen (43, 44) angeordnet ist.

11. Anordnung nach einem der vorhergehenden Ansprüche, ferner umfassend ein Transportsicherungselement (16), welches eingerichtet ist, in dem Steckerkragen (33) aufgenommen zu werden, um die Leiterplatte (2) zu sichern.

## Claims

1. Electronic arrangement comprising:
- a circuit board (2) having at least one electric contact (22) for making the electrical contact,
- a housing (3) in which the circuit board (2) is arranged, and
- a plug collar (33) that is arranged on the housing (3),
- wherein the circuit board (2) comprises a first circuit board half (24) having a mounting (4) for the purpose of supporting the circuit board (2), and a second circuit board half (25), wherein the at least one electric contact (22) of the circuit board (2) is arranged in the region of the plug collar (33) in order to make it possible to make direct contact with the electric contact,
**characterized in that**
- the circuit board (2) is supported on the mounting (4) in such a manner that the mounting (4) defines a pivot region about which the circuit board (2) can pivot, said pivot region being in particular a pivot axis of the circuit board (2),
- wherein a first spring element (34) and a second spring element (35) are arranged on the plug collar (33), thus resulting in centring of the circuit board (2) if a plug is inserted into the plug collar (33) and the electric contacts of the plug come into contact with the electric contacts (22) of the circuit board, and
- wherein, after direct electric contact has been established between he circuit board (2) and the plug, the circuit board (2) is symmetrically fixed between the spring elements (34, 35) on the plug collar (33).

2. Arrangement according to Claim 1, **characterized in that** the mounting (4) comprises on the housing (3) a first mounting pin (8) and a second mounting pin (9) that are arranged lying opposite one another on the housing, and the circuit board (2) is mounted between said pins.

3. Arrangement according to Claim 2, **characterized in that** the circuit board (2) comprises a through-going opening (20, 21) into which the first and/or second mounting pin (8, 9) protrudes.

4. Arrangement according to Claim 3, **characterized in that** the first mounting pin (8) is conical in shape and the second mounting pin (9) is in the form of a hollow cylinder.

5. Arrangement according to any one of the preceding claims, **characterized in that** the mounting (4) comprises a first mounting region (5) and a second mounting region (6) and each mounting region (5, 6) comprises a first and second mounting pin (8, 9; 10, 11).

6. Arrangement according to Claim 5, **characterized in that** a straight line through the first and second mounting region (5, 6) is perpendicular to a plug-in direction (Z) in which a plug is inserted into the plug collar (33).

7. Arrangement according to Claim 5 or 6, further comprising an electronic component (7) that is arranged on the circuit board (2) between the first mounting region (5) and the second mounting region (6).

8. Arrangement according to any one of the preceding claims, **characterized in that** the circuit board (2) protrudes at least in part into the plug collar (33).

9. Arrangement according to any one of the preceding claims, further comprising a second mounting (40) that comprises at least one flexible element (41, 42), preferably two flexible elements, in order to support the circuit board (2) in a flexible manner on the second circuit board region (25).

10. Arrangement according to Claim 9, **characterized in that** the flexible element (41, 42) is arranged at the through-going opening (36) of the housing (3) towards the plug collar (33), or that the flexible element (41, 42) is arranged on the retaining pin (43, 44) that is provided on the housing (3).

11. Arrangement according to any one of the preceding claims, further comprising a transportation lock element (16) that is designed so as to be received in the plug collar (33) in order to secure the circuit board (2).

## Revendications

1. Dispositif électronique comprenant :
- une carte de circuit imprimé (2) comportant au moins un contact électrique (22) permettant une mise en contact électrique,
- un boîtier (3), dans lequel est disposée la carte de circuit imprimé (2), et
- un collet de fiche (33) disposé contre le boîtier (3),
- dans lequel la carte de circuit imprimé (2) présente une première moitié de carte de circuit imprimé (24) pourvue d'un support (4) destiné à supporter la carte de circuit imprimé (2) et une seconde moitié de carte de circuit imprimé (25),
dans lequel l'au moins un contact électrique (22) de la carte de circuit imprimé (2) est disposé dans la zone du collet de fiche (33) afin de permettre une mise en contact directe du contact électrique,
**caractérisé en ce que**
- la carte de circuit imprimé (2) est supportée sur le support (4) de telle manière que le support (4) définisse une zone de pivotement, en particulier un axe de pivotement, de la carte de circuit imprimé (2) autour duquel la carte de circuit imprimé (2) peut pivoter,
- dans lequel des premier et second éléments à ressort (34, 35) sont disposés sur le collet de fiche (33) de manière à centrer la carte de circuit imprimé (2) lorsqu'une fiche est introduite dans le collet de fiche (33) et que les contacts électriques de la fiche viennent au contact des contacts électriques (22) de la carte de circuit imprimé, et
- dans lequel, après qu'un contact électrique direct a été établi entre la carte de circuit imprimé (2) et le connecteur, la carte de circuit imprimé (2) est fixée symétriquement entre les éléments à ressort (34, 35) sur le collet de fiche (33).

2. Dispositif selon la revendication 1, **caractérisé en ce que** le support (4) disposé contre le boîtier (3) comprend un premier tourillon de support (8) et un second tourillon de support (9), qui sont disposés contre le boîtier en face l'un de l'autre et qui supportent entre eux la carte de circuit imprimé (2).

3. Dispositif selon la revendication 2, **caractérisé en ce que** la carte de circuit imprimé (2) présente une ouverture de passage (20, 21) dans laquelle pénètrent le premier et/ou le second tourillon de support (8, 9).

4. Dispositif selon la revendication 3, **caractérisé en ce que** le premier tourillon de support (8) est conique et **en ce que** le second tourillon de support (9) est un cylindre creux.

5. Dispositif selon l'une des revendications précédentes, **caractérisé en ce que** le support (4) comprend une première zone de support (5) et une seconde zone de support (6) et **en ce que** chaque zone de support (5, 6) comprend des premier et second tourillons de support (8, 9 ; 10, 11).

6. Dispositif selon la revendication 5, **caractérisé en ce qu'**une ligne droite passant à travers les première et deuxième zones de support (5, 6) est perpendiculaire à une direction d'enfichage (Z) suivant laquelle une fiche est introduite dans le collet de fiche (33).

7. Dispositif selon la revendication 5 ou 6, comprenant en outre un composant électronique (7) qui est disposé sur la carte de circuit imprimé (2) entre la première zone de support (5) et la seconde zone de support (6).

8. Dispositif selon l'une des revendications précédentes, **caractérisé en ce que** le circuit imprimé (2) pénètre au moins partiellement dans le collet de fiche (33) .

9. Dispositif selon l'une des revendications précédentes, comprenant en outre un second support (40) qui comprend au moins un élément flexible (41, 42), de préférence deux éléments flexibles, pour supporter élastiquement la carte de circuit imprimé (2) sur la seconde zone de carte de circuit imprimé (25).

10. Dispositif selon la revendication 9, **caractérisé en ce que** l'élément flexible (41, 42) est disposé sur la traversée (36) du boîtier (3) vers le collet de fiche (33) ou **en ce que** l'élément flexible (41, 42) est disposé sur des tourillons de maintien (43, 44) prévus sur le boîtier (3).

11. Dispositif selon l'une des revendications précédentes, comprenant en outre un élément de fixation (16) destiné au transport, qui est conçu pour être reçu dans le collet de fiche (33) afin de fixer la carte à circuit imprimé (2).
